# EUROPEAN PATENT APPLICATION

(11) **EP 2 995 881 A1**
(43) Date of publication of application: **16.03.2016**
(21) Application number: 15183154.2
(22) Date of filing: 31.08.2015
(51) Int. Cl.: F24J 1/00

(54) **PHOTOVOLTAIC TREE**

(30) Priority: 02.09.2014 IT BG20140028 U
(71) Applicant: Lussana, Stefano, 24061 Albano Sant'Alessandro, Bergamo (IT)
(72) Inventor: Lussana, Stefano, 24061 Albano Sant'Alessandro, Bergamo (IT)
(74) Representative: Eterno, Enrico

(57) **Abstract**

Urban furnishing structure provided with at least one solar panel comprising: an inner metal structure; a layer of synthetic greenery placed over said inner metallic structure; at least one photovoltaic panel attached to said inner metal structure.

## Description

This invention relates to an urban furnishing structure, in particular to an urban furnishing structure equipped with solar panels. More particularly, it relates to a photovoltaic tree covered with synthetic greenery such as to resemble a tree.

There are various types of structures supporting solar panels that provide power and charge batteries for different purposes such as lighting, telecommunications, surveillance, etc.

These solutions, which require batteries, control units, inverters and other components, are, for the most part, functional but unsightly because all of the electronics must be placed on a pole or similar.

The purpose of this invention is to provide an urban furnishing structure equipped with solar panels that is aesthetically pleasing and at the same time can be confused with a tree.

Another purpose is to provide an urban furnishing structure that is effective for the production of electricity.

A further purpose is to provide an urban furnishing structure that integrates with the surrounding environment.

According to this invention, these purposes and others are achieved by an urban furnishing structure equipped with at least one solar panel comprising: an inner metal structure; a layer of synthetic greenery placed over said inner metallic structure; at least one photovoltaic panel attached to said inner metal structure.

Further characteristics of the invention are described in the dependent claims.

There are various advantages of this solution compared to the solutions of the known art.

Thanks to this invention we can obtain electricity that is self-sufficient and beautiful to behold, a work that is not invasive and perfectly integrated into the surrounding environment.

For example, in a private garden, this invention can be used as an ornament, integrating lighting and powering the existing lighting, or simply expanding the electrical system.

It can be placed in a public park, a private home, on a main or secondary road, a traffic circle, etc.

The exterior may be of various colours and types to better adapt to the surrounding environment such as light ivy green, photinia, cyclamen, red maple and boxwood. Even the solar panel can be matched with the most suitable colour.

The characteristics and advantages of this invention will become apparent from the following detailed description of an embodiment, illustrated by way of nonlimiting example in the accompanying drawings, in which:

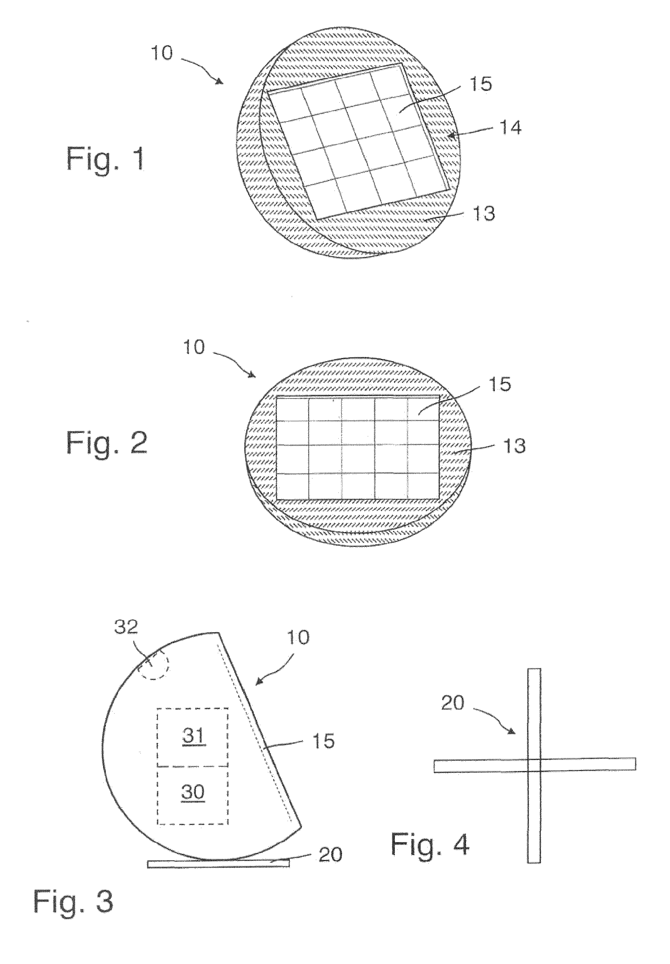

Figure 1 schematically shows an urban furnishing structure, seen in perspective, according to this invention;
Figure 2 schematically shows an urban furnishing structure, seen from the front, according to this invention;
Figure 3 schematically shows an urban furnishing structure, seen from the side, according to this invention;
Figure 4 schematically shows an urban furnishing structure, seen from above, according to this invention;

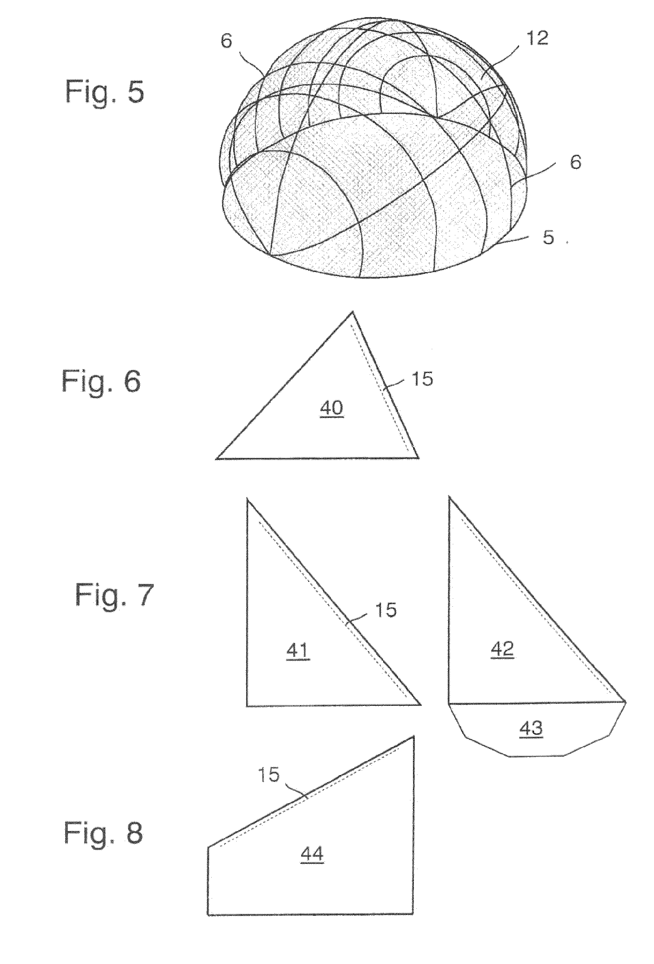

Figure 5 schematically shows the inner structure of an urban furnishing structure, seen transparently from the side, according to this invention;
Figure 6 schematically shows an urban furnishing structure, seen from the side, according to a first variant of this invention;
Figure 7 schematically shows an urban furnishing structure, seen from the side, according to a second variant of this invention;
Figure 8 schematically shows an urban furnishing structure, seen from the side, according to a third variant of this invention.

Referring to the accompanying drawings, an urban furnishing structure 10, according to this invention, comprises an inner structure 11, preferably made of metal to create a support cage of the structure 10 itself. In particular, it can be made with sufficiently strong steel or aluminium wire, such as for example of a diameter of 5 mm.

Around the cage is placed a preferably metal netting 12 (for example with a mesh of 1-5 cm) to form the inner surface of the structure 10.

The structure 11 and the netting 12 are joined together by welding or mechanical joining with screws and bolts.

For example, a structure 11 with a hemispherical shape can be made by preparing a basic metal circumference 5 (made with a metal bar, for example of a diameter of 5 mm) and fixing perpendicularly to it a series of semicircles 6 (also made with a metal bars similar to the previous) of variable height, first increasing and, after the middle of the base circumference, then decreasing, so that the envelope of such bars creates a hemisphere. The various bars can then be linked together by suitable means.

Above this structure 11 is placed a netting 12 (or equivalent devices) to form the surface of the hemisphere.

Above the metal netting 12 is placed a carpet of synthetic greenery 13 that completely covers the structure 10 and forms the outer surface of the structure 10.

The synthetic greenery 13 is fixed on the netting 12 by gluing and/or by means of fastenings and/or hooks.

The synthetic greenery 13 is of the type that is normally used to cover the fences of homes or the railings of terraces or to mask structures and is sold for example in square sheets of 50x50 cm or 100x100cm.

The shape of the urban furnishing structure 10 is typically in the shape of a hemisphere. A solar panel 15 is placed on the flat surface of the hemisphere 14.

In particular, a recess is prepared on the flat surface 14 of the hemisphere in which the solar panel 15 is placed so that it is flush with the surface 14.

The urban furnishing structure 10 rests on the ground and, given its hemispherical shape, rests placing the plane of the solar panel with the most suitable inclination for collecting the greatest amount of sunshine hours.

To facilitate installation and to avoid any unintended rotation of the structure 10, a base 20 is provided, for example made with two rods crossed and fastened to the inner structure 11 in a position such as to give the exact inclination to the solar panel 15.

Other embodiments of the urban furnishing structure 10 may be used as, for example, a pyramid 40, a triangular prism 41 or a prism shape with trapezoidal base 42, like a hedge with the upper surface inclined. Still other shapes are possible.

The synthetic greenery 13 is preferably coloured green and, in any case, such that the urban furnishing structure 10 can be integrated into the surrounding environment, mingling with the vegetation and real trees.

Other colours can be used if the surrounding environment requires it.

The photovoltaic panel 15 can be the usual blue colour but it is preferable to use solar panels 15 of the coloured type, even better those of the type with the texture and colour of fake leaves, which adapt better to the synthetic greenery 13 and the surrounding environment.

To this point, we have described an urban furnishing panel 10 associated with one solar panel, but the size of the structure 10 may vary and a structure 10 can accommodate several photovoltaic panels.

The photovoltaic panels can be used individually or electrically coupled with each other and supply energy to the power grid.

The urban furnishing structure 10 has an internal volume delimited by the inner structure 11, which is empty and thus can be used to contain any batteries 30 to store the electricity produced by the photovoltaic panel 15 and any electronics 31 to control the battery charge and/or inverter.

It can also include one or more lamps 32 placed on the structure 10 and powered directly by the solar panel 15 or by batteries charged by it.

The structure 10 can also be positioned on a suitably dimensioned pole, a few metres from the ground, so as to resemble a tree, and also to protect the components installed inside and outside the structure itself. The pole is fixed to the metal bars 5 and/or 6, on one side and the other side is suitably fixed to the ground for example in a concrete base.

## Claims

1. Urban furnishing structure provided with at least one solar panel comprising: an inner metal structure; a layer of synthetic greenery placed over said inner metallic structure; at least one photovoltaic panel attached to said inner metal structure.

2. Structure according to claim 1, **characterized in that** it comprises a netting placed on said inner metal structure and said layer of synthetic greenery is placed on said netting.

3. Structure according to one of the preceding claims, **characterized in that** said structure has the shape of a hemisphere.

4. Structure according to one of the preceding claims **characterized in that** it comprises at least one lamp powered directly by said at least one photovoltaic panel.

5. Structure according to one of the preceding claims, **characterized in that** it comprises at least one lamp powered by a battery charged by said at least one photovoltaic panel.

6. Structure according to one of the preceding claims, **characterized in that** said at least one photovoltaic panel is coloured.

7. Structure according to one of the preceding claims, **characterized in that** said inner metal structure comprises a basic metal circumference, a series of metal semicircles fixed perpendicularly to it, of variable height, first increasing and, after the middle half of the basic circumference, decreasing.

8. Structure according to one of the preceding claims, **characterized in that** said structure comprises inside batteries and electronics controlling the charging of said batteries.
